Europäisches Patentamt

European Patent Office

Office européen des brevets

(11) Publication number: **0 495 114 A1**

## EUROPEAN PATENT APPLICATION
### published in accordance with Art. 158(3) EPC

(21) Application number: 91913114.4

(22) Date of filing: **25.07.91**

(86) International application number:
**PCT/JP91/01001**

(87) International publication number:
**WO 92/02051 (06.02.92 92/04)**

(51) Int. Cl.⁵: **H01L 27/115**

(30) Priority: **26.07.90 JP 198797/90**

(43) Date of publication of application:
**22.07.92 Bulletin 92/30**

(84) Designated Contracting States:
**DE FR GB IT NL**

(71) Applicant: **SEIKO EPSON CORPORATION**
**4-1, Nishishinjuku 2-chome**
**Shinjuku-ku Tokyo 163(JP)**

(72) Inventor: **KATO, Koji**
**3-5, Owa 3-chome**
**Suwa-shi, Nagano-ken 392(JP)**

(74) Representative: **Ouinterno, Giuseppe et al**
**c/o Jacobacci-Casetta & Perani S.p.A. Via**
**Alfieri, 17**
**I-10121 Torino(IT)**

(54) SEMICONDUCTOR DEVICE.

(57) A nonvolatile storage device using a ferroelectric film and being excellent in the property that information can be rewritten many times can be obtained, by integrating the ferroelectric film on a semiconductor substrate through forming either one or both of electrodes (10) and (12) with oxide conductors. The electrodes (10) and (12) are provided on two diffusion layers (3) and (4) of high concentration to be a source and drain formed on the semiconductor substrate, and a ferroelectric material (11) is sandwiched between the two electrodes.

FIG. 1

## Technical Field

The present invention relates to a semiconductor device with the use of a ferroelectric, particularly relates to an electrically rewritable non-volatile semiconductor memory device.

## Background Art

As a prior art semiconductor non-volatile memory, there is commonly used an MIS-type transistor by using such a phenomenon that the surface potential of a silicon substrate is modulated by injecting an electric charge from the silicon substrate into a trap or a floating gate among insulating gates, which is practically used as EPROM (ultraviolet erasing type non-volatile memory), EEPROM (electrically rewritable non-volatile memory) and the like.

However, these non-volatile memories have such disadvantages that an information rewriting voltage is usually high such as about 20 V, and a rewriting time is very long (such as several ten msec in case of EPROM) and the like. Moreover, the number of rewriting information is only about $10^5$, which is very few, and troublesome when the memory is used repetitively.

A non-volatile memory with the use of a ferroelectric, which polarization is electrically reversible, has substantially the same write-in time and read-out time in principle, and can maintain polarization even if a power supply is cut off, and as a result, has a possibility to be an ideal non-volatile memory. Such non-volatile memory with the use of a ferroelectric has been proposed as a structure integrating capacitor consisting of a ferroelectric on a silicon substrate in U.S. Patent No. 4,159,302, and a non-volatile memory arranging a ferroelectric film on the gate portion of an MIS-type transistor in U.S. Patent No. 3,832,700 and the like. However, these memories cannot practically be used yet because a ferroelectric capacitor is not suitable for integration or reliability is low. Therefore, the present invention is to solve such problems, and aims to improve reliability to oxygen anneal of the electrodes of the ferroelectric capacitor and to provide an excellent non-volatile semiconductor memory device.

## Disclosure of the Invention

The present invention is to obtain a non-volatile memory having an excellent number of rewriting information by integrating a ferroelectric film on a semiconductor substrate by forming either one or both electrodes sandwiching the ferroelectric into an oxide conductor on a high concentration diffusion layer to be source and drain formed on the semiconductor substrate in structure of a memory with the use of a ferroelectric film.

## Brief Description of the Drawings

Fig. 1 is a cross section of a semiconductor device according to an embodiment of the present invention.

Figs. 2(a)-(c) are cross sections of the major steps of the semiconductor device according to an embodiment of the present invention.

Fig. 3 is a cross section of a semiconductor device according to prior technique.

## Best Mode for carrying out the Invention

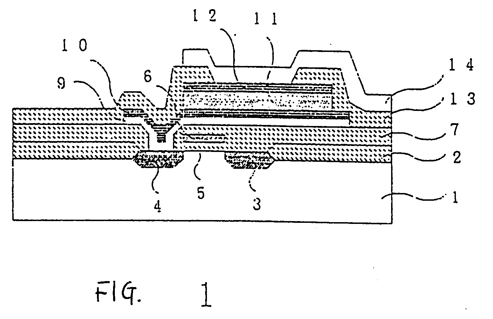

Fig. 1 is a cross section of a semiconductor memory device according to an embodiment of the present invention.

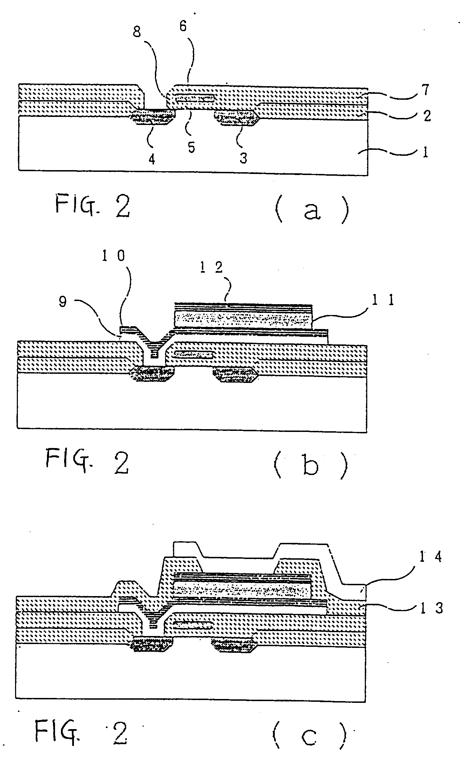

Fig. 2 is a cross section of the major steps of the semiconductor memory device according to an embodiment of the present invention.

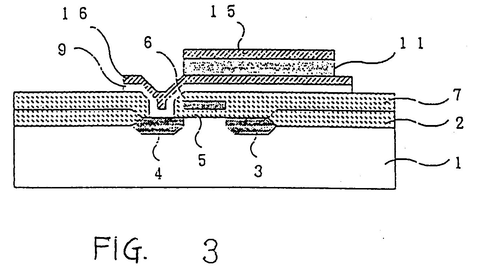

Fig. 3 is a cross section of a semiconductor memory device according to prior technique.

Reference numeral 1 shows a semiconductor substrate, 2 an element separating film, 3 and 4 are source and drain regions by an n-type diffusion layer respectively, 5 a gate film, 6 a gate electrode, 7 an interlayer insulating film, 8 a connecting hole (hereinafter referred to as "contact hole"), 9 a lower electrode barrier metal layer, 10 a lower electrode, 11 a ferroelectric film, 12 an upper electrode, 13 an interlayer insulating film, 14 a wiring layer of the upper electrode, 15 an upper electrode with the use of metal, and 16 a lower electrode with the use of metal.

As a prior structure of a non-volatile memory with the use of ferroelectric film, as shown in Fig. 3, for the electrodes of the capacitor of a memory cell use were made of metal electrodes 15 and 16 such as platinum and the like, and for a barrier metal 9 such as titanium, titanium nitride and the like. A non-volatile memory manufactured by such a structure, if it is annealed in an atmosphere containing oxygen at 600°C for one hour, it causes peeling-off of the lower electrode 16 of metal such as platinum and the like. When this cause is examined in detail, it has been found that a barrier metal 9 such as titanium, titanium nitride and the like had been oxidized. Therefore, the present embodiment uses an oxide conductor such as ITO (mixture of indium oxide and tin oxide) and the like as at least a lower electrode, thereby intercepting diffusion of oxygen, and causing no oxidation of barrier metal such as titanium, titanium nitride and the like even after the above annealing. Moreover, it is obvious this effect can be materialized by making both the upper and the lower electrodes oxide conductors such as ITO.

The semiconductor device of the present invention will be explained by referring to Fig. 2 as follows. For the sake of explanation, here is explained an example of connecting a capacitor of the present invention to a source or a drain of an MOS transistor formed on a p-type Si substrate.

(Fig. 2(a)) 1 is a p-type Si substrate, using a substrate having specific resistance of 20 $\Omega \cdot$ cm. 2 is an insulating film for separating an element, formed into about 600 Å by LOCOS method. 6 becomes a gate electrode. For example, it is polysilicon, formed in film thickness of 4000 Å. 3 and 4 are n-type diffusion layers which become source and drain of MOS transistor, formed by injecting $4 \times 10^{15}$ cm$^{-2}$ of phosphorus by ion implantation. 5 is a gate film, formed in thickness of 300 Å. 7 is an interlayer insulating film for separating a gate electrode and lower electrodes, formed in 6000 Å by vapor phase growing method. 8 is a contact hole between the layer 4 provided in the film 7 and a lower electrode barrier metal layer 9. In the steps so far, it is sufficiently possible to manufacture by using prior technique.

(Fig. 2(b)) Next, a lower electrode barrier metal layer of a ferroelectric film of 500 Å is formed by sputtering Ti as shown by 9. As the lower electrode 9, ITO of 3000 Å is formed, and a predetermined pattern is formed by using exposure technique as prior art. Next, as a ferroelectric film 11, PbTiO$_3$ is formed into 5000 Å by sputtering and annealed in an atmosphere containing O$_2$ at 600°C for one hour.

Next, as an upper electrode 12, ITO is formed into 3000 Å by sputtering. Next, a ferroelectric film 11 and an upper electrode 12 are formed into predetermined patterns by using prior art exposure technique.

(Fig. 2(c)) 13 is an interlayer insulating film for separating a lower electrode 10, an upper electrode 12 and a wiring layer 14, formed into 6000 Å by vapor phase growing of SiO$_2$ for example.

Next, a contact hole between the upper electrode 12 and the wiring layer 14 is formed by prior exposure technique, and as a wiring layer 14, Al of 5000 Å is formed by sputtering. Finally, a pattern of the wiring layer 14 is formed by using prior art exposure technique, and a structure of the present invention is obtained.

Industrial Applicability

As stated above, according to the semiconductor device of the present invention, an oxide conductor is used for an electrode of a ferroelectric capacitor, so that the present invention has an effect of providing an excellent semiconductor memory device enabling to prevent reliability from lowering together with oxidation of electrode base material owing to annealing in oxygen atmosphere.

Claims

1. A semiconductor device integrating a ferroelectric film on a same semiconductor substrate forming an active element thereon via electrodes formed by sandwiching the ferroelectric film, characterized in that one or both of the two electrodes formed by sandwiching the ferroelectric film is an oxide conductor.

2. A semiconductor device as claimed in claim (1), wherein said oxide conductor consists essentially of either one of ITO (mixed crystal of indium oxide and tin oxide), ruthenium oxide, rhenium oxide, tungsten oxide, chromium oxide, and molybdenum oxide.

FIG. 1

FIG. 2          ( a )

FIG. 2          ( b )

FIG. 2          ( c )

FIG. 3

# INTERNATIONAL SEARCH REPORT

International Application No PCT/JP91/01001

**I. CLASSIFICATION OF SUBJECT MATTER** (if several classification symbols apply, indicate all) [6]

According to International Patent Classification (IPC) or to both National Classification and IPC

Int. Cl[5] H01L27/115

**II. FIELDS SEARCHED**

| Minimum Documentation Searched [7] | |
|---|---|
| Classification System | Classification Symbols |
| IPC | H01L27/115, 29/792, 27/12 |

Documentation Searched other than Minimum Documentation
to the Extent that such Documents are Included in the Fields Searched [8]

Jitsuyo Shinan Koho      1970 - 1990
Kokai Jitsuyo Shinan Koho    1972 - 1990

**III. DOCUMENTS CONSIDERED TO BE RELEVANT [9]**

| Category * | Citation of Document, [11] with indication, where appropriate, of the relevant passages [12] | Relevant to Claim No. [13] |
|---|---|---|
| Y | JP, A, 2-183570 (Seiko Epson Corp.), July 18, 1990 (18. 07. 90), Line 10, upper right column to line 7, lower right column, page 2 | 1 |
| A | JP, A, 64-4721 (Seiko Epson Corp.), January 9, 1989 (09. 01. 89), Lines 2 to 12, lower left column, page 2 | 1, 2 |

\* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| October 21, 1991 (21. 10. 91) | October 28, 1991 (28. 10. 91) |
| International Searching Authority | Signature of Authorized Officer |
| Japanese Patent Office | |

Form PCT/ISA/210 (second sheet) (January 1985)